Europäisches Patentamt

(19) European Patent Office

Office européen des brevets

(11) Publication number: **0 013 149**
**B1**

(12) # EUROPEAN PATENT SPECIFICATION

(45) Date of publication of patent specification: **06.04.83**

(51) Int. Cl.³: **H 04 H 5/00, H 03 D 3/00**

(21) Application number: **79302992.7**

(22) Date of filing: **20.12.79**

(54) FM stereo signal demodulator.

(30) Priority: **25.12.78 JP 160435/78**

(43) Date of publication of application:
**09.07.80 Bulletin 80/14**

(45) Publication of the grant of the patent:
**06.04.83 Bulletin 83/14**

(84) Designated Contracting States:
**DE FR GB NL·**

(56) References cited:
**DE - A - 2 461 134**
**DE - A - 2 534 310**
**US - A - 3 634 626**
**US - A - 3 790 714**
**US - A - 3 798 376**
**US - A - 4 032 717**

**FUNKSCHAU, Vol. 47, No. 10, 1975 München
D. Mallon "Monolithischer PLL-Stereo-Decoder"
pages 193 to 196**

(73) Proprietor: **TOKYO SHIBAURA DENKI KABUSHIKI KAISHA**
**72, Horikawa-cho Saiwai-ku**
**Kawasaki-shi Kanagawa-ken 210 (JP)**

(72) Inventor: **Hashimoto, Masaru**
**1425-12, Fukaya ayasemachi**
**Koza-gun Kanagawa-ken (JP)**

(74) Representative: **Batchellor, John Robert et al,**
**BATCHELLOR, KIRK & EYLES 2 Pear Tree Court**
**Farringdon Road**
**London EC1R 0DS (GB)**

Courier Press, Leamington Spa, England.

## 0 013 149

### FM stereo signal demodulator

This invention relates to an FM stereo signal demodulator for separating a composite FM stereo signal into separate left and right signals, and in particular, relates to an FM stereo signal demodulator wherein the amplitude of the switching signal of 38 kHz necessary to separate the composite signal into the left and right signal is varied, thereby making it possible to alter the degree of left and right separation and to achieve a good signal to noise ratio (S/N) over a wide range of electric field strength.

When an FM stereo signal is received, under conditions in which the electric field strength is not very much higher than the limiting sensitivity of the receiver, stereo reception is adversely affected in S/N by nearly 20dB in comparison with monaural reception. The S/N ratio varies depending on the degree of separation in the stereo condition, being worse the greater the degree of separation. In known systems, it is usual to provide means for switching the receiver to "mono" under poor signal conditions.

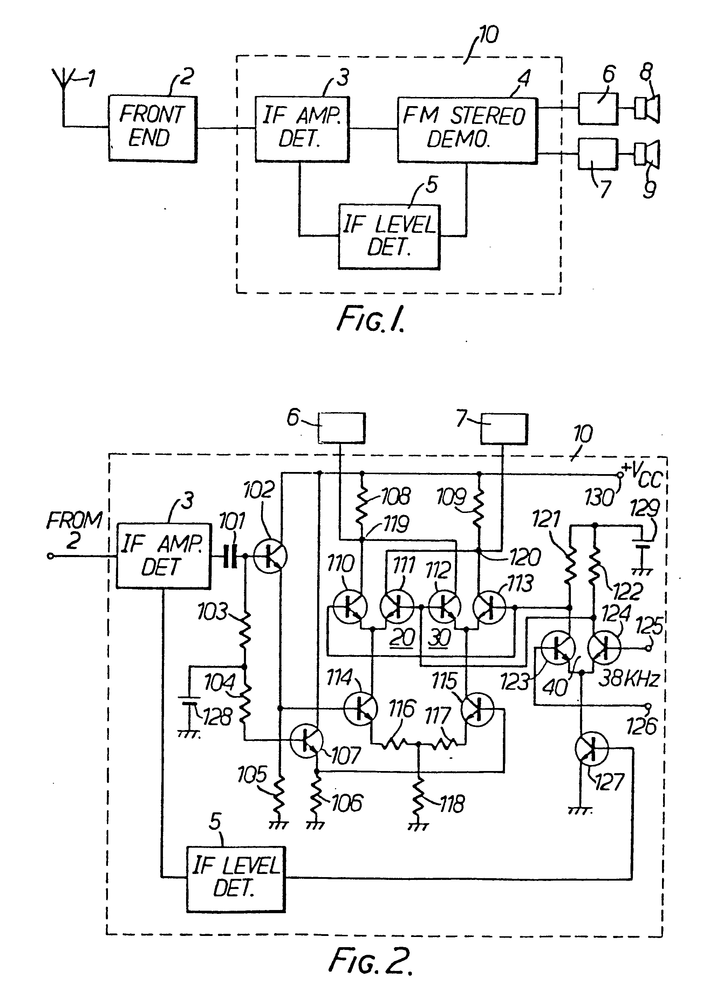

Another type of approach is exemplified by German Offenlegungschrift No. 25 34 310, which shows in Figures 4 and 5, a parallel filter circuit which has the effect of attenuating all the signal components around 38 kHz. This reduces the stereo separation purely as a result of the partial suppression of the (L—R) component of the audio signal, which of course is located around the 38 kHz band of the signal spectrum. However it increases the distortion of the output signal and is thus a generally undesirable approach. DE—AS 24 61 134 also only discloses attenuation of the (L—R) signal (see claims 7 and 8) either in its coded or decoded forms and U.S. patent 4,032,717 discloses a very similar approach, see Figure 1, in which an attenuator is shown in the L—R channel after the synchronous demodulator.

The present invention provides an FM stereo demodulator for separating a composite signal into separate left and right signals by means of a switching signal, including a demodulator circuit having a signal input to which an output signal from an IF amplifier circuit is applied, and a pair of switching signal inputs to which a switching signal is applied so as to operate the demodulator to alternately select left and right signal components and supply them to respective audio signal outputs, and also including an IF level detector connected to the IF amplifier characterised in that the output from the IF level detector is supplied as a gain control signal to a variable gain amplifier circuit for the said switching signal so as to continuously vary the amplitude of the switching signal and thus the stereo separation, in accordance with, and in the same sense as, the said IF level.

Thus the present invention, in contrast to the above mentioned prior art, alters the stereo separation by specifically changing the amplitude of the 38 kHz switching signal, and thereby adjusts the operation of the synchronous demodulators symmetrically, avoiding any increase of distortion.

One embodiment of the invention will now be described by way of example only with reference to the drawings, in which:

Figure 1 is a block diagram of an FM stereo signal receiver according to the present invention;

Figure 2 shows a preferred embodiment of the part enclosed by the dotted lines in Figure 1; and

Figure 3 shows the relationship between the output of the IF level detector (Figure 1) and the separation of the stereo signal demodulator.

Referring to Figure 1, the FM carrier wave including the (L+R) signal, the AM suppressed carrier of 38 kHz modulated by the (L—R) signal, and the pilot signal of 19 kHz etc. is received at an antenna 1, and supplied to the circuit 2 (usually called the "front end"). This circuit 2 comprises a radio frequency amplifier (RF Amp.), the local oscillator (osc), and mixer, and supplies the intermediate frequency (IF). The output signal is supplied to the next IF Amp. and to the FM detector 3, to obtain the composite signal. This composite signal is supplied to the FM stereo signal demodulator 4, while part of the output from the IF amp. is supplied to the IF level detector 5. This IF level detector 5 supplies a DC voltage, in accordance with the IF signal, to the FM stereo signal demodulator 4. This output from the IF level detector 5 is used to control the separation of the demodulator 5. Thus when the electric field strength of the received signal is high this output is supplied to the demodulator 5 to make the separation great, and when the strength is low the ouput is supplied to make the separation small.

The separated left and right signals are supplied to the Audio Frequency Amplifiers (AF Amp.) 6 and 7 and thence to the loudspeakers 8 and 9.

Figure 2 shows a preferred embodiment of the part of Figure 1 enclosed by dotted lines.

The composite signal from the detector 3 is supplied via capacitor 101 to the base of transistor 102 operating as an emitter follower. The emitter of transistor 102 is grounded through resistance 105, and its collector is connected to power supply terminal 130. The signal appearing at the emitter of transistor 102 is supplied to the base of a first input transistor 114.

A DC bias source 128 is connected to the base of transistor 102 and to a second emitter follower 107 through resistances 103 and 104 respectively. As the junction of the resistances 103 and 104 is ground to any alternating signal, the composite signal is not supplied to the base of transistor 115.

The emitter of transistor 107 is grounded through resistance 106, and its collector is connected to the power supply terminal 130. The collector of the first input transistor 114 is connected to the junction of the emitters of a pair of transistors 110 and 111 which are operated as a first synchronous demodulator 20. The collectors of these transistors are connected to the power supply terminal 130 through resistances 108 and 109 respectively.

The emitter of transistor 114 is connected to the emitter of the second input transistor 115 through the resistances 116 and 117, and the junction of resistances 116 and 115 is grounded through resistance 118.

The collector of the second input transistor 115 is connected to the emitters of a pair of transistors 112 and 113 which are operated as a second synchronous demodulator 30, the collectors of these transistors being connected to the collectors of transistors 110 and 111 respectively. In this way the outputs of said first synchronous demodulator 20 and said second synchronous demodulator 30 are added. The left and right signals which appear at the output terminals 119 and 120 are supplied to the AF amplifiers 6 and 7.

An output from the IF level detector 5 is supplied to the base of a third input transistor 127. The IF level detector 5 detects the output of the IF Amp. 3, and rectifies the output to a DC voltage before applying it to transistor 127. Usually the output of IF level detector is also used to drive a Signal Strength Meter.

The emitter of the third input transistor 127 is grounded, and its collector is connected to the junction of the emitters of a pair of transistors 123 and 124 operating as a differential amplifier circuit 40. The collectors of these transistors 123 and 124 are connected to the DC voltage source 129 through resistances 121 and 122 respectively. The 38 kHz switching signal is applied to the bases of these transistors 123 and 124, via terminals 125 and 126. This 38 kHz signal is, for example, obtained from the 19 kHz pilot signal to be doubled by a frequency doubler (not shown). The collector of transistor 123 is connected to the bases of transistors 110 and 113, and the collector of transistor 124 is connected to the bases of the transistors 111 and 112. Therefore the pairs of transistors 110 and 113, 111 and 112, are kept in the same conductive condition. That is to say, when transistors 111 and 112 are conductive, transistors 110 and 113 are nonconductive and vice versa at the next half cycle of the 38 kHz switching signal. In operation, a synchronous demodulator of the type used as the demodulator 20 produces a substantially equal and predictable amount of undesirable crosstalk at each of the output terminals 119 and 120. So we can express the output of the first synchronous demodulator 20 by the following equations:

$$L_1 = L + \Delta R \tag{1}$$

$$R_1 = R + \Delta L \tag{2}$$

wherein $L_1$ is the output of the transistor 110, and $R_1$ is the output of the transistor 111; L being the left signal component, and R the right signal component; and $\Delta R$, $\Delta L$ are the crosstalk components of the R and L signals respectively.

The composite signal applied to the second synchronous demodulator 30 is supplied through the resistances 116, 117 to the emitter of the second input transistor 115 from the emitter of the first input transistor 114. Thus the composite signal to be supplied to the second demodulator 30 is out of phase with the composite signal supplied to the first synchronous demodulator 20, and so if the ratio of the composite signal at the collector of transistor 114 to that at the collector of transistor 115 is l:l/k, the output of the second synchronous demodulator 30 can be expressed as:

$$L_2 = -\frac{l}{k}(L + \Delta R) \tag{3}$$

$$R_2 = -\frac{l}{k}(R + \Delta L) \tag{4}$$

wherein $L_2$ and $R_2$ are signals which appear at the collectors of transistors 112 and 113 respectively. Therefore the sum signals which appear at the output terminals 119 and 120 can be expressed as:

$$L_0 = (L + \Delta R) - \frac{l}{k}(R + \Delta L)$$

$$= (L - \frac{\Delta}{k}L) + (\Delta R - \frac{l}{k}R) \tag{5}$$

$$R_0 = (R + \Delta L) - \frac{I}{k}(L + \Delta R)$$

$$= (R - \frac{\Delta}{k}R) + (\Delta L - \frac{I}{k}L) \tag{6}$$

wherein $L_0$ appears at the output terminal 119, $R_0$ at 120.

Therefore if $\Delta = I/k$, $L_0$ and $R_0$ comprise only L or R signal components respectively. This adjustment of k can be achieved by controlling the value of resistances 116, 117 and 118.

In this situation, when the field strength of the received FM stereo signal, and thus the output from the IF level detector 5 becomes small, the collector current of the third input transistor 127 becomes small. Therefore the collector currents of the transistors 123 and 124 also decrease, and in consequence the amplitude of the 38 kHz switching signal to be supplied to the first and second synchronous demodulators 20 and 30 is reduced. When the amplitude of the 38 kHz switching signal is reduced, the switching operation of the transistors of the first and second synchronous demodulators becomes insufficient, to provide maximum separation of the left and right signals. The ratio of the collector current of the transistor 110 to 111, or 113 to 112 can be expressed as follows:

$$I_{c110} : I_{c111} = I_{c113} : I_{c112} = a : (I - a) \tag{7}$$

or

$$I_{c110} : I_{c111} = I_{c113} : I_{c112} = (I - a) : a \tag{8}$$

wherein $I_{c110}$, $I_{c111}$, $I_{c112}$ and $I_{c113}$

are the collector current of transistors 110, 111, 112 and 113 respectively "a" having a value in the range $0.5 \leqq a \leqq 1$.

In this situation the output which appears at the output terminal 119 can be expressed as follows:

In a first half cycle of the switching signal when the ratio of the collector current is $I_{c110} : I_{c111} = a : (I - a)$,

$$L_{01} = (L + \Delta R) \cdot a - \frac{I}{k} \cdot (L + \Delta R) \cdot (I - a)$$

$$= L \cdot (a - \frac{I}{k} + \frac{a}{k}) + R \cdot (\Delta a - \frac{\Delta}{k} + \frac{a}{k}) \tag{9}$$

Likewise when $I_{c110} : I_{c111} = (I - a) : a$,
namely at the next half cycle of the 38 kHz switching signal,

$$L_{02} = (R + \Delta L) \cdot (I - a) - \frac{I}{k}(R + \Delta L) \cdot a$$

$$= L \cdot (\Delta - \Delta a - \frac{\Delta a}{k}) + R \cdot (I - a - \frac{a}{k}) \tag{10}$$

Consequently, the output over a whole cycle expressed by the sum of equation (9) and (10) is

$$L_0 = L_{01} + L_{02} = L \cdot (a - \frac{I}{k} + \frac{a}{k} + \Delta - \Delta a - \frac{\Delta a}{k}) + R \cdot (\Delta a - \frac{\Delta}{k} + \frac{\Delta a}{k} + I - a - \frac{a}{k})$$

$$= L \cdot a \cdot (I - \frac{\Delta}{k}) + R(I - a) \cdot (I - \frac{\Delta}{k}) \tag{11}$$

Likewise the output which appears at the output terminal 120 is

4

$$R_0 = R \cdot a \cdot (l - \frac{\Delta}{k}) + L(l-a)(l - \frac{\Delta}{k}) \qquad (12)$$

and the separation S is

$$S = 20 \log_{10} \cdot \frac{l-a}{a} (dB) \qquad (13)$$

The condition of perfect separation occurs when $a=l$, and the outputs are

$$L_0 = L \cdot (l - \frac{\Delta}{k}) \qquad (14)$$

$$R_0 = R \cdot (l - \frac{\Delta}{k}) \qquad (15)$$

These equations can be obtained from the equations (5) and (6) also by substituting $\Delta = l/k$. On the other hand when $a=0.5$

$$L_0 = 0.5L(l - \frac{\Delta}{k}) + 0.5R(l - \frac{\Delta}{k}) \qquad (16)$$

$$R_0 = 0.5R(l - \frac{\Delta}{k}) + 0.5L(l - \frac{\Delta}{k}) \qquad (17)$$

The separation is then 0 (dB).
The voltage difference between the collectors of transistors 123 and 124 is

$$V_{BB38} = \frac{kT}{q} \ln \frac{l_2}{l_1} \qquad (18)$$

wherein q: the charge of an electron, k: Boltzman's constant, T: absolute temperature, $l_1$: collector currents of transistors 110, 113, $l_2$: collector current of transistors 111, 112.

$$\text{when } l_1 : l_2 = a : (l-a) \qquad (19)$$

$$l_2 = \frac{l-a}{a} l_1 \qquad (20)$$

therefore from equations (20) and (18)

$$V_{BB38} = \frac{kT}{q} \ln \frac{l-a}{a} \qquad (21)$$

and also the separation S is, from the equations (13) and (21)

$$S = 20 \log_{10} (e^{\frac{q}{kT} V_{BB38}})$$

$$= 20 \cdot \frac{q}{kT} V_{BB38} \log_{10} e$$

$$= 8.68 \cdot \frac{q}{kT} V_{BB38} (dB) \qquad (22)$$

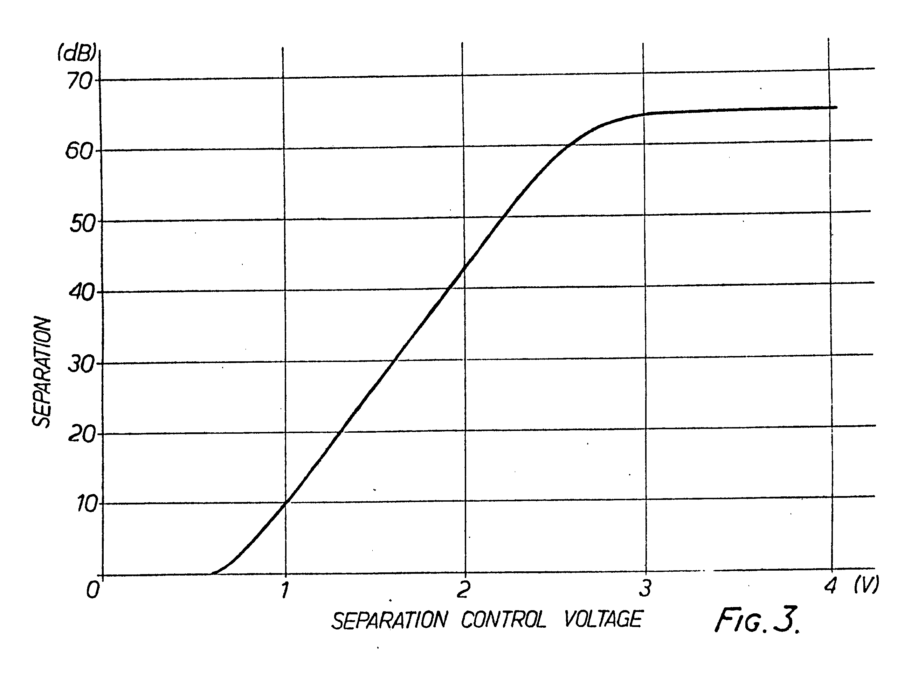

This equation (22) shows that the separation S varies in proportion to the $V_{BB38}$. This relationship is shown in Figure 3 which shows the relationship between the separation of the FM stereo signal demodulator and the separation control voltage supplied to the base of the transistor 127. In the embodiment shown in Figure 2 $V_{BB38}$ is varied by varying the voltage drop of the resistances 121 and 122 by controlling the separation control voltage.

## Claims

1. An FM stereo demodulator for separating a composite signal into separate left and right signals by means of a switching signal, including a demodulator circuit (4) having a signal input to which an output signal from an IF amplifier circuit (3) is applied, and a pair of switching signal inputs to which the switching signal is applied so as to operate the demodulator to alternately select left and right signal components and supply them to respective audio signal outputs (6, 7), and also including an IF level detector (5) connected to the IF amplifier, characterised in that the output from the IF level detector (5) is supplied as a gain control signal to a variable gain amplifier circuit (123, 124, 127) for the said switching signal so as to continuously vary the amplitude of the switching signal and thus the stereo separation, in accordance with, and in the same sense as, the said IF level.

2. An FM stereo demodulator according to claim 1, in which the variable gain amplifier is a differential amplifier including a pair of transistors (123, 124) having their emitters coupled together, the bases of the transistors comprising the differential inputs to which the switching signal is applied, in use; and further including a variable impedance device 127 connected between the junction of the said emitters and ground, whereby the said gain control signal is applied to the variable impedance device to vary the gain of the said amplifier.

3. An FM stereo demodulator according to claim 2, in which the said variable impedance device comprises a transistor (127) whose collector is connected to the junction of the emitters of the said pair of transistors (123, 124), and whose emitter is connected to ground and whose base comprises the input for the said gain control signal.

4. An FM stereo demodulator according to claim 3, in which the demodulator circuit comprises a pair of synchronous demodulators (20, 30), the first of the demodulators having an input (114) which is supplied with the composite signal, and the input (115) of the second of the demodulators being supplied with an attenuated anti-phase signal; each demodulator having a pair of switching inputs (110, 111; 112, 113) to which the differential outputs of the said variable gain differential amplifier (40) are connected.

5. An FM stereo demodulator as claimed in claim 1 in which the switching signal is at 38 kHz.

## Revendications

1. Démodulateur de signaux stéréophoniques à modulation de fréquence servant à subdiviser un signal composite en des signaux de gauche et de droite séparés au moyen d'un signal de commutation, du type comprenant un circuit démodulateur possédant une entrée des signaux, à laquelle est appliqué un signal de sortie provenant d'un circuit amplificateur de fréquence intermédiaire (3), et deux entrées du signal de commutation, auxquelles le signal de commutation est appliqué de manière à faire fonctionner le démodulateur de manière qu'il sélectionne en alternance les composantes du signal de gauche et du signal de droite et les envoie à des sorties respectives (6, 7) de signaux à basse fréquence, et comportant également un détecteur de niveau de fréquence intermédiaire (5) raccordé à l'amplificateur à fréquence intermédiaire, caractérisé en ce que le signal de sortie du détecteur de niveau de fréquence intermédiaire (5) est envoyé en tant que signal de commande de gain à un circuit amplificateur à gain variable (123, 124, 127) prévu pour ledit signal de commutation de manière à modifier de façon continue l'amplitude de ce signal et par conséquent la séparation stéréophonique en conformité avec et dans le même sens que ledit niveau de fréquence intermédiaire.

2. Démodulateur de signaux stéréophoniques à modulation de fréquence selon la revendication 1, caractérisé en ce que l'amplificateur à gain variable est un amplificateur différentiel contenant deux transistors (123, 124) dont les émetteurs sont accouplés l'un à l'autre et dont les bases constituent les entrées différentielles auxquelles le signal de commutation est appliqué, en cours de fonctionnement, et qui contient en outre un dispositif à impédance variable (127) raccordé entre les points de jonction desdits émetteurs à la masse, ce qui a pour effet que le signal de commande de gain est appliqué au dispositif à impédance variable de manière à modifier le gain dudit amplificateur.

3. Démodulateur de signaux stéréophoniques à modulation de fréquence selon la revendication 2, caractérisé en ce que ledit dispositif à impédance variable est constitué par un transistor (127) dont le collecteur est raccordé au point de jonction des émetteurs dudit couple de transistors (123, 124) et dont l'émetteur est raccordé à la masse, tandis que sa base constitue l'entrée du signal de commande du gain.

4. Démodulateur de signaux stéréophoniques à modulation de fréquence selon la revendication 3, caractérisé en ce que le circuit démodulateur se compose de deux démodulateurs synchrones (20, 30), dont le premier comporte une entrée (114) qui est alimentée par le signal composite, tandis que

# 0013149

l'entrée (115) du second desdits démodulateurs est alimentée par un signal déphasé atténué, chaque démodulateur comportant deux entrées de commutation (110, 111, 112, 113) auxquelles sont appliqués les signaux de sortie différentiels dudit amplificateur différentiel à gain variable (40).

5. Démodulateur de signaux stéréophoniques à modulateur de fréquence, selon la revendication 1, caractérisé en ce que le signal de commutation possède une fréquence de 38 kHz.

**Patentansprüche**

1. Mit Frequenzmodulation arbeitender Stereo-Demodulator oder FM-Stereo-Demodulator, der unter Verwendung eines Schaltsignales ein Signalgemisch oder Mischsignal in rechte Signale und linke Signale zu trennen und zu zerlegen hat. Zu diesem FM-Stereo-Demodulator gehören:— eine Demodulatorschaltung mit einem Signaleingang, der das Ausgangssignal einer Zwischenverstärkerschaltung (ZF-Verstärkerschaltung) (13) aufgeschaltet erhält, sowie mit zwei Schaltsignaleingängen, denen das Schaltsignal derart aufgeschaltet und damit der Demodulator derart angesteuert und ausgesteuert wird, daß dieser in selektiver Weise entweder die linken oder die rechten Signalkomponenten auswählt und diese dann zuden jeweils zutreffenden Ausdiosignal-Ausgängen (6, 7) weiterleitet. Zu diesem Stereo-Demodulator gehört weiterhin auch noch ein Zwischensignalpegel-Detektor (ZF-Signaldetektor) (5), der schaltungsmäßig mit dem Zwischenverstärker (ZF-Verstärker) verbunden ist. Der FM-Stereo-Demodulator dadurch gekennzeichnet, daß das Ausgangssignal des ZF-Signalpegeldetektors (5) als ein Verstärkungsregelungssignal auf eine verstärkungsveränderliche Verstärkungsschaltung (123, 124, 127) für das bereits angeführte Schaltsignal geführt wird, und zwar derart, daß die Amplitude des Schaltsignales kontinuierlich und stetig—damit aber auch die Stereo-Trennung—geändert wird, und dies in Übereinstimmung und im gleichen Sinne wie der Pegel des Zwischenfrequenzsignales oder ZF-Signales.

2. Frequenzmodulation-Stereo-Demodulator oder FM-Stereo-Demodulator nach Anspruch 1, dadurch gekennzeichnet, daß der versärkungsvariable Verstärker wie ein Differentialverstärker ausgeführt ist. Zu diesem Differentialverstärker gehören: die beiden Transistoren (123, 124), deren Emitter miteinander verbunden sind und deren Basisanschlüsse die Differentialeingänge darstellen, die im Betrieb das Schaltsignal aufgeschaltet erhalten; weiterhin auch noch eine impedanzvariable Vorrichtung (127), die schaltungsmäßig zwischen den Verknüpfungsstellen der vorerwähnten Emitter und der Erde/Masse angeordnet ist, wobei das bereits genannte Verstärkungsregelungssignal der impedanzvariablen Vorrichtung oder Schaltung derart aufgeschaltet wird, daß dasurch die Verstärkung des bereits angeführten Verstärker eine Änderung erfährt.

3. Frequenzmodulation-Stereo-Demodulator oder FM-Stereo-Demodulator nach Anspruch 2, dadurch gekennzeichnet, daß zur vorerwähnten impedanzvarablen Vorrichtung oder Schaltung ein Transistor (127) gehört, der mit seinem Kollektor auf Verknüpfungspunkt zwischen den Emittern der bereits angeführten beiden Transistoren (123, 124) geführt ist und mit seinem Emitter mit Erde oder Masse verbunden ist, wobei die Basis dieses Transistors (127) den Eingang für das bereits genannte Verstärkungsregelungssignal darstellt.

4. Frequenzmodulation-Stereo-Demodulator oder FM-Stereo-Demodulator nach Anspruch 3, dadurch gekennzeichnet, daß sich die Demodulatorschaltung aus zwei synchronen Demodulatoren (20, 30) zusammensetzt, wobei der erste Demodulator einen Eingang (114) aufweist, der das Signalgemisch oder Mischsignal aufgeschaltet erhält, wobei weiterhin der zweite der Demodulatoren einen Eingang (115) aufweist, der ein gedämpftes und abgeschwächtes Antiphasensignal aufgeschaltet erhält. Jeder der Demodulatoren weist zwei Schalteingänge (110, 111, 112, 113) auf, mit denen die Differentialsignalausgänge des bereits angeführten verstarkungsvariablen Differentialverstärkers (40) in Verbindung stehen.

5. Frequenzmodulation-Stereo-Demodulator oder FM-Stereo-Demodulator nach Anspruch 1, dadurch gekennzeichnet, daß das Schaltsignal eine Frequenz von 38 KHz hat.

7

Fig.1.

Fig.2.

SEPARATION CONTROL VOLTAGE

FIG. 3.

0013149